# EUROPEAN PATENT SPECIFICATION

(11) **EP 2 755 267 B1**
(45) Date of publication and mention of the grant of the patent: **02.08.2017**
(21) Application number: 14164006.0
(22) Date of filing: 14.05.2007
(51) Int. Cl.: H01M 6/14, H01M 2/22, H01M 2/10, H01M 2/26, H01M 2/30, H01M 4/04, H01M 6/40, H01M 10/052, H01M 10/0562, H01M 4/1391, H01L 23/58, H01M 10/04, H01M 4/525, H01M 2/02, H01M 4/40, H01M 4/02

(54) **Thin film battery on an integrated circuit or circuit board and method thereof**
Dünnschichtbatterie auf einer integrierten Schaltung oder Platine und Verfahren dafür
Batterie à film mince sur circuit intégré ou carte de circuit imprimé et procédé associé

(30) Priority: 12.05.2006 US 799904 P
(43) Date of publication of application: 16.07.2014
(62) Divisional of application: 07797463.2
(73) Proprietor: Sapurast Research LLC, Wilmington, DE 19801 (US)
(72) Inventor: Johnson, Raymond R., Denver, CO 80224 (US); Snyder, Shawn W., Golden, CO 80401 (US); Brantner, Paul C., Conifer, CO 80433 (US); Bradow, Timothy J., Littleton, CO 80127 (US); Neudecker, Bernd J., Littleton, CO 80127 (US)
(74) Representative: Barnfather, Karl Jon

(56) References cited:
- WO-A2-2004/093223
- WO-A2-2005/067645
- US-A- 4 518 661
- US-A1- 2004 214 079
- US-A1- 2006 021 214

## Description

### FIELD OF THE INVENTION

The field of this invention is the device, composition, method of depositing and fabrication of flexible solid-state, thin-film, secondary and primary electrochemical devices, including batteries, onto a semiconducting surface, onto a conductive or insulating surface of a semiconductor device, such as integrated circuit chips, or onto a circuit board, such as printed circuit board.

### BACKGROUND

Typical electrochemical devices comprise multiple electrically active layers such as an anode, cathode, electrolyte, substrate, current collectors, etc. Some layers, such as, for example, an anode layer comprising lithium, are comprised of materials that are very environmentally sensitive. The substrate may, for example, not be a separate battery element but instead be provided by a semiconducting surface or onto a conductive or insulating packaging surface of a semiconductor device to which the battery is attached. Such batteries require an encapsulation to protect such environmentally sensitive material. Some schemes encapsulate the sensitive layers of electrochemical devices, such as encapsulation with gold foil. Other schemes encapsulate the device with pouch, for example, made of metal and plastic, that seals around the perimeter of the device.

WO 2005/067645 discloses a layered barrier structure for a system that includes a thin-film battery such as one that includes lithium or lithium compounds connected to an electronic circuit. An environmental barrier is deposited as alternating layers. At least one of the layers provides a smoothing, planarizing, and/or leveling physical-configuration function, and at least one other layer provides a diffusion-barrier function.

### SUMMARY

According to a first aspect of the invention, there is provided an integrated circuit including a battery according to appended claim 1. According to a second aspect of the invention, there is provided a method of manufacturing a battery on a first electrical contact according to appended claim 9. Preferable features of the invention are defined in the appended dependent claims.

An exemplary embodiment of the present invention includes a battery fabricated on a semiconductor chip or fabricated on a flexible printed circuit board. The battery includes a first electrical contact, a bonding layer coupled with the first electrical contact and having a first embedded conductor, at least one battery cell structure in selective electrical contact with said first electrical contact via the first embedded conductor, a semiconducting surface or a conductive or insulating packaging surface of a semiconductor device.

The bonding layer coupled with the semiconducting surface or a conductive or insulating packaging surface of a semiconductor device may have more than one conductor, such an optional, second embedded conductor, which in turn creates an optional, selective electrical contact of the semiconducting surface or a conductive or insulating packaging surface of a semiconductor device with said first electrical contact. In any case, the bonding layer and the at least one battery cell structure may be sandwiched between the first contact layer and the semiconducting surface or the conductive or insulating packaging surface of a semiconductor device.

The first electrical contact may, for example, include an encapsulate metal. The bonding layer may be an adhesive material, an insulating material, a plastic, a polymeric material, glass, and/or fiberglass. An insulative reinforcement layer may be embedded within the bonding layer. Such a reinforcement layer may be selectively conductive. The conductor may be, for example, a tab, a wire, a metal strip, a metal ribbon, multiple wires, multiple metal strips, multiple metal ribbons, a wire mesh, perforated metal, a metal coating applied to the adhesive layer, or a disk. The conductor may be woven within the bonding layer and the bonding layer may include a slit within which the embedded conductor is woven.

The battery cell structure may include an anode, an electrolyte, a cathode, and a barrier layer. The cathode may, for example, not be annealed at all, annealed at lower temperatures, or annealed at higher temperatures, by using convection furnaces, rapid thermal anneal methods, or by a laser annealing and/or crystallization process.

Another exemplary embodiment of the present invention includes a method of manufacturing a thin film battery comprising, in no particular order, the steps of creating a selectively conductive bonding layer, coupling the bonding layer with a first contact layer, coupling a first side of a battery cell structure with a semiconducting surface or a conductive or insulating surface of a semiconductor device or flexible printed circuit board, and coupling a second side of the battery cell structure with the bonding layer. Optionally, the bonding layer may be made selectively conductive at an additional location at which the selectively conductive boding layer creates an electrical contact between the first contact layer and the semiconducting surface or a conductive or insulating surface of a semiconductor device or flexible printed circuit board. Yet another exemplary embodiment of the present invention includes a method of manufacturing a thin film battery comprising, in no particular order, the steps of creating a selectively conductive bonding layer, coupling the bonding layer with a first contact layer, coupling a first side of a battery cell with the first contact layer as well, coupling the bonding layer with the a semiconducting surface or a conductive or insulating surface of a semiconductor device or flexible printed circuit board, and coupling a second side of the battery cell structure with the bonding layer.

Examples of this embodiment may include creating a battery cell structure with an anode, cathode, and electrolyte layers, embedding at least one conductor within the bonding layer, weaving at least one conductive wire through the bonding layer wherein selective portions of the conductive wire are exposed, heating the bonding layer and compressing the conductor within the bonding layer, and insulating the battery with an insulating material. This exemplary embodiment may include providing an insulative reinforcement layer embedded within the bonding layer. The reinforcement layer may be selectively conductive.

Yet another exemplary embodiment of the present invention involves a battery on a flexible printed circuit board wherein the first side of the battery cell structure is at least in direct mechanical contact with the flexible printed circuit board. The battery includes a first electrical contact, a bonding layer coupled with the first electrical contact and comprising [Sigma]L[Alpha] first embedded conductor, at least one battery cell structure in selective electrical contact with the first electrical contact via the first embedded conductor, the bonding layer coupled with the first electrical contact and comprising a second embedded conductor that is in selective electrical contact with the first electrical contact and the flexible printed circuit board. The bonding layer and the at least one battery cell structure are sandwiched between the first contact layer and a flexible printed circuit board.

Another exemplary embodiment of the present invention involves a battery on a flexible printed circuit board wherein the battery cell structure is not in direct mechanical contact with the flexible printed circuit board but mechanically separated by at least the bonding layer. The battery includes a first electrical contact, a bonding layer coupled with the first electrical contact and comprising a first embedded conductor, at least one battery cell structure in selective electrical contact with the first electrical contact via said first embedded conductor, the bonding layer coupled with the flexible printed circuit board and having an optional, second embedded conductor in the bonding layer, which in turn creates an optional, selective electrical contact of the flexible printed circuit board with said first electrical contact. The bonding layer and the at least one battery cell structure are sandwiched between the first contact layer and a flexible printed circuit board.

In another exemplary embodiment, a method of manufacturing a thin film battery includes creating a selectively conductive bonding layer, coupling the bonding layer with a first contact layer, coupling a first side of a battery cell structure with a flexible printed circuit board; and coupling a second side of the battery cell structure with the bonding layer.

In yet another exemplary embodiment, a method of manufacturing a thin film battery includes creating a selectively conductive bonding layer, coupling the bonding layer with a first contact layer, coupling a first side of a battery cell structure with the first contact layer; and coupling a second side of the battery cell structure with the selectively conductive bonding layer, and coupling the bonding layer with the flexible printed circuit board.

Another exemplary embodiment of the present invention includes the electrical connection between the battery cell and the semiconducting surface or the conductive packaging surface of a semiconductor device. The electrical connection between the battery cell and the semiconducting surface or the conductive packaging surface of a semiconductor device can be made by direct physical contact or by wire bonding.

In another aspect, prior to its integration onto the semiconducting surface or a conductive or insulating packaging surface of a semiconductor device or into or onto a flexible printed circuit board, the battery may be fabricated as a discrete device and then integrated as a whole together with its substrate and its encapsulation.

Another embodiment of the present invention includes the electrical connection between a multi-battery cell stack and the semiconducting surface or the conductive packaging surface of a semiconductor device.

### BRIEF DESCRIPTION OF THE FIGURES

FIG. 1A shows a side view of an example of a thin film battery with a semiconducting surface or the conductive or insulating surface of a semiconductor device or a flexible printed circuit board according to an exemplary embodiment of the present invention.
FIG. 1B shows a side view of another example of a thin film battery with a semiconducting surface or the conductive or insulating packaging surface of a semiconductor device or a flexible printed circuit board according to an exemplary embodiment of the present invention.
FIG. 2 shows a side view of an example of a thin film battery with a semiconducting surface or the conductive or insulating surface of a semiconductor device according to another exemplary embodiment of the present invention.
FIG. 3A shows a side view of an exemplary thin film battery on a semiconducting surface or the conductive or insulating packaging surface of a semiconductor device or a flexible printed circuit board according to another exemplary embodiment of the present invention.
FIG. 3B shows a side view of an exemplary thin film battery on a semiconducting surface or the conductive or insulating surface of a semiconductor device or flexible printed circuit board according to another exemplary embodiment of the present invention.
FIG. 3C shows a top view of an exemplary thin film battery on a semiconducting surface or the conductive or insulating surface of a semiconductor device or flexible printed circuit board according to another exemplary embodiment of the present invention.
FIG. 4A shows a side view of an exemplary thin film battery on a semiconducting surface or the conductive or insulating surface of a semiconductor device according to another exemplary embodiment of the present invention.
FIG. 4B shows a side view of an exemplary thin film battery on a flexible printed circuit board according to another exemplary embodiment of the present invention.

### DETAILED DESCRIPTION

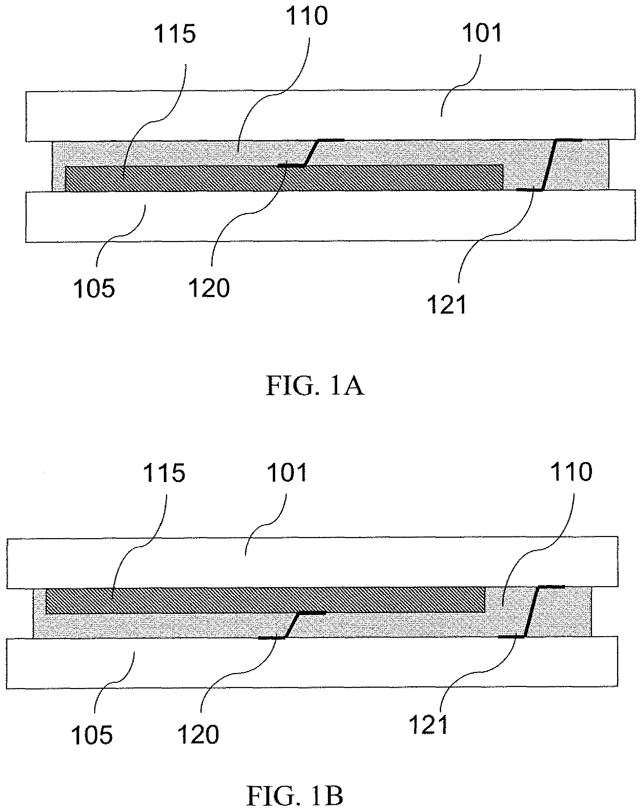

FIG. 1A shows a side view of an electrochemical device according to one exemplary embodiment of the present invention. In this embodiment, a first contact 101 is coupled with bonding layer 110 with a portion of the first contact 101 extending past the bonding layer 110. The bonding layer 110 may, for example, be bonded with the cell structure 115. A semiconducting surface or the conductive or insulating surface of a semiconductor device 105 is placed under the battery cell structure 115. An insulating surface of the semiconductor device 105 may be, for example, an insulating packaging surface of a semiconductor device or an upper insulating surface the semiconductor device. A conductive surface may include, for example, a conductive contact pad, a conductive line, conductive via or other conductive layer formed on or at the device surface. A conductive surface also may be formed together with an insulating surface, such as a conductive surface formed on a packaging surface of a semiconductor device. Shown embedded within the bonding layer 110 is a first embedded conductor 120. This first embedded conductor 120, for example, creates a selectively conductive bonding layer. A selectively conductive bonding layer 110 permits conduction from the cell structure 115 through the bonding layer 110 to the first contact 101 at specific points, and yet provides insulation between the first contact 101 and the semiconducting surface or the conductive or insulating surface of a semiconductor device 105. Other types of battery cell structures may be also be included.

The electrochemical device may have a second embedded conductor 121 that selectively creates an electrical contact between the first contact 101 and the semiconducting surface or the conductive or insulating packaging surface of a semiconductor device 105. In this case, the semiconducting surface or the conductive or insulating surface of a semiconductor device 105 must be selectively insulating between the contacts points at which the first embedded conductor 120 and the second embedded conductor 121 meet the semiconducting surface or the conductive or insulating (e.g., packaging) surface of a semiconductor device 105.

FIG. IB shows a side view of an electrochemical device according to an exemplary embodiment of the present invention. In this embodiment, a first contact 101 is coupled with the battery cell structure 115. A bonding layer 110 is coupled to the battery cell structure 115 and a portion of the first contact 101, which extends past the bonding layer 110. A semiconducting surface or the conductive or insulating surface of a semiconductor device 105 is coupled with the bonding layer 110. Shown embedded within the bonding layer 110 is the first embedded conductor 120. This first embedded conductor 120, for example, creates a selectively conductive bonding layer. A selectively conductive bonding layer 110 permits conduction from the cell structure 115 through the bonding layer 110 to the semiconducting surface or the conductive or insulating (e.g., packaging) surface of a semiconductor device 105 at specific points, and yet provides insulation between the first contact 101 and the semiconducting surface or the conductive or insulating surface of a semiconductor device 105. The electrochemical device may have a second embedded conductor 121 that selectively creates an electrical contact between the first contact 101 and the semiconducting surface or the conductive or insulating surface of a semiconductor device 105. In this case the semiconducting surface or the conductive or insulating surface of a semiconductor device 105 must be selectively insulating between the contact points at which the first embedded conductor 120 and the second embedded conductor 121 meet the semiconducting surface or the conductive or insulating packaging surface of a semiconductor device 105. The first embedded conductor 120 and the second embedded conductor 121 may be placed within the bonding layer 110 in many different ways. For example, a metal tab, a metal wire, a metal strip, a metal ribbon, multiple metal wires, multiple metal strips, multiple metal ribbons, a metal wire mesh, perforated metal foil, perforated metal, a metal coating applied to the adhesive layer, a metallic disk, a metallically coated fiberglass or combinations thereof may be used. In each of these examples, the first embedded conductor 120 and the second embedded conductor 121 can provide electrical conduction between the cell structure 115 and the first contact 101 and the boding layer 110 provides insulation between the first contact 101 and the semiconducting surface or the conductive or insulating surface of a semiconductor device 105. In some embodiments, the embedded conductors 120 and 121 may be woven within the bonding layer 110. The embedded conductors 120 and 121 may be, for example, disks embedded within the bonding layer 110. In some embodiments slits within the bonding layer 110 may be made in order to weave or place the embedded conductors 120 and 121 through the bonding layer 110. Also, for example, holes or other means may be used to place the embedded conductors 120 and 121 through the bonding layer 110.

In another exemplary embodiment of the present invention, a reinforcement layer may be placed within the bonding layer. For example, a fiberglass material may cover half of one surface of the bonding layer, woven through the layer and then cover the other half of the bonding layer. Such a layer of fiberglass without a conductive coating would insulate the materials placed between. The fiberglass may be coated in a localized area with a conductive material. Such conductive coatings can coat the fiberglass area in the top and bottom surface of the bonding layer. In such an embodiment, for example, the fiberglass may conduct between the upper contact and the cell. Conductive material may be disposed on the fiberglass using ink jet, silk screen, plasma deposition, e-beam deposition, spray and/or brush methods. Other materials may be used rather than fiberglass, such as, for example, Kevlar", plastic, glass or other insulating materials.

Another exemplary embodiment of the present invention may provide for selective contact between the first contact and the battery cell structure through holes in the bonding layer. In such an embodiment, holes in the bonding layer may allow the first contact and battery cell structure to remain in contact. The layers may be, for example, pressed together to create a contact. Alternatively, conductive glues or inks may be applied in or near the hole area in the bonding layer to make the contact between the layers. Lithium may also be used.

The embedded conductors 120 and 121 and/or first contact, for example, may be made of gold, platinum, stainless steel, titanium, vanadium, chromium, manganese, iron, cobalt, nickel, copper zirconium, niobium, molybdenum, hafnium, tantalum, tungsten, aluminum, indium, tin, silver, carbon, bronze, brass, beryllium, or oxides, nitrides, carbides, and alloys thereof. The first contact may be a metal foil, for example, may be made of stainless steel or any other metallic substance having the necessary or suitable characteristics and properties such as a requisite amount of conductivity. The metal foil may preferably comprise a solderable alloy, for instance, alloys of copper, nickel, or tin. The first contact may be, for example, less than 100 microns thick, less than 50 microns thick, or less than 25 microns thick.

The electrochemical device 115 may include a cathode, anode and electrolyte. For example, the cathode may comprise LiCoO₂, the anode may comprise Lithium and the electrolyte may comprise LIPON. Other electrochemical devices may be used as needed.

The electrochemical device 115 may be coupled with the semiconducting surface or the conductive or insulating packaging surface of a semiconductor device 105 in a number of ways. In one embodiment, the electrochemical device, for example, may be coupled with the semiconducting surface or the conducting or insulating surface of a semiconductor device 105 using glue. Glue, as used in this application, extends to any material that may adhere the electrochemical device 115 to the semiconducting surface or the conducting or insulating surface of a semiconductor device 105. The glue may create either a mechanical or chemical bond between the two layers. Glue may also include chemically bonding the two layers without introducing another material or layer. Glue, for example, may include but is not limited to cement glue and resin glue. The glue may be electrically conducting, semi-conducting, or insulating.

In another exemplary embodiment, the semiconducting surface or the conductive or insulating (e.g., packaging) surface of a semiconductor device 105 acts as a substrate for the battery. The semiconducting surface or the conductive or insulating packaging surface of a semiconductor device 105 is provided and the electrochemical device 115 may be deposited thereon. The electrochemical device 115 may also be glued to the semiconducting surface or the conductive or insulating packaging surface of a semiconductor device 105.

In an exemplary embodiment, a LiCoO₂ cathode layer is deposited on the semiconducting surface or the conducting or insulating surface of a semiconductor device 105. A number of deposition techniques are known in the art, these include, but are not limited to reactive or non-reactive RF magnetron sputtering, reactive or non-reactive pulsed DC magnetron sputtering, reactive or non-reactive DC diode sputtering, reactive or non-reactive thermal (resistive) evaporation, reactive or non-reactive electron beam evaporation, ion-beam assisted deposition, plasma enhanced chemical vapor deposition, or deposition methods, which may include, for example, spin coating, ink-jetting, thermal spray deposition, dip coating or the like. As part of the fabrication process, for example, the cathode may be annealed using a thermal anneal such as anneal at lower temperatures, anneal at higher temperatures, or by using convection furnaces or rapid thermal anneal methods. Another or an alternative post-deposition anneal may include laser annealing to improve the crystallization of the LiCoO₂ layer so as to fine-tune and optimize its chemical properties, such as its electrochemical potential, its energy, its power performance, and its reversible lattice parameters on electrochemical and thermal cycling.

Following deposition of the cathode layer, an electrolyte may be deposited on the cathode, followed by an anode. Again, these layers may be deposited by any of a number of processes common in the art. In one specific embodiment, once the electrochemical device 115 has been deposited on the semiconducting surface or the conducting or insulating surface of a semiconductor device 105, a bonding layer 110 may be placed between the electrochemical device and a first electrical contact 101. In this specific embodiment shown in FIG. IA, a metal encapsulate layer 101 may also be the first contact. In another specific embodiment, once the electrochemical device 115 has been deposited on the first electrical contact 101, a bonding layer 110 may be placed between the electrochemical device 115 and the semiconducting surface or the conducting or insulating surface of a semiconductor device 105. In this specific embodiment shown in FIG. IB, a metal encapsulate layer 101 may also be the first contact. As described above, the first contact may be a metal foil, for example, may be made of stainless steel or any other metallic substance having the necessary characteristics and properties such as a requisite amount of conductivity. The metal foil may preferably comprise a solderable alloy, for instance, alloys of copper, nickel, or tin. The first contact may be, for example, less than 100 microns thick, less than 50 microns thick, or less than 25 microns thick.

The bonding layer 110 may include, for example, an adhesive material, an insulating material, polymeric material, glass, Kevlar<(R)>, reinforcement materials, and fiberglass. The embedded conductors 120 and 121 may include, for example, a tab, a wire, a metal strip, a metal ribbon, multiple wires, multiple metal strips, multiple metal ribbons, a wire mesh, perforated metal, a metal coating applied to the adhesive layer, and a disk.

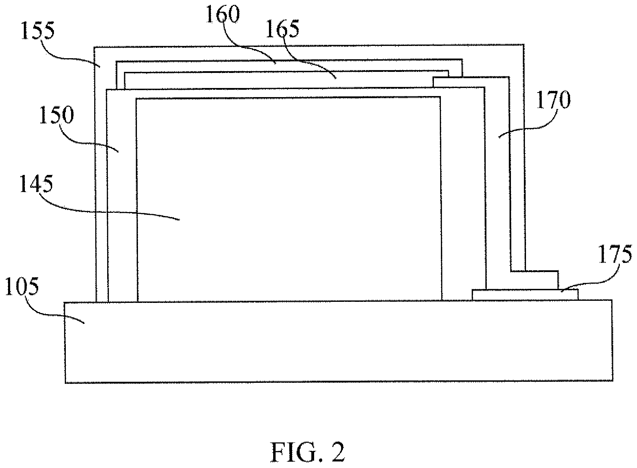

FIG. 2 shows a second embodiment of a thin film battery on a chip. In this embodiment the battery may include a semiconducting surface or the conductive or insulating packaging surface of a semiconductor device 105, a cathode layer 145 deposited on the semiconducting surface or the conductive or insulating packaging surface of a semiconductor device 105, an electrolyte 150, an anode 165, a modulating layer 160, an encapsulate 155, an anode current collector 170 and an insulator 175. For example, the cathode 145 may comprise LiCoO₂, the anode 160 may comprise Lithium and the electrolyte 150 may comprise LIPON. Other electrochemical devices may be used as needed. The encapsulate 155 may comprise a ceramic-metal composite laminate of a multiple of alternating layers of Zirconium Nitride and Zirconium or Titanium Nitride and Titanium.

The electrochemical device which may include the cathode 145, electrolyte 150 and anode 155, may be semiconducting surface or the conductive or insulating packaging surface of a semiconductor device 105 in a number of ways. In one embodiment, the electrochemical device, for example, may be coupled with the substantially conductive, semiconducting surface or the conductive packaging surface of a semiconductor device 105 using glue. Glue, as used in this application, extends to any material that may adhere parts of the electrochemical device to the semiconducting surface or the conductive or insulating packaging surface of a semiconductor device 105. The glue may create either a mechanical or chemical bond between the two layers. Glue may also include chemically bonding the two layers without introducing another material or layer. The glue may be electrically conductive in order to use the semiconducting surface or the conductive or insulating packaging surface of a semiconductor device 105 as current collector. Glue, for example, may include but is not limited to electrically conductive cement glue and resin glue.

The cathode 145 may also be deposited directly on the semiconducting surface or the conductive or insulating packaging surface of a semiconductor device 105. In a specific embodiment, a LiCoO₂ cathode layer is deposited on semiconducting surface or the conductive or insulating packaging surface of a semiconductor device 105. A number of deposition techniques are known in the art, these include, but are not limited to reactive or non-reactive RF magnetron sputtering, reactive or non-reactive pulsed DC magnetron sputtering, reactive or non- reactive DC diode sputtering, reactive or non-reactive thermal (resistive) evaporation, reactive or non-reactive electron beam evaporation, ion-beam assisted deposition, plasma enhanced chemical vapor deposition, deposition methods, which may include, for example, spin coating, ink-jetting, thermal spray deposition, dip coating or the like. As part of the fabrication process for example, a post-deposition laser anneal may be used to improve the crystallization of the cathode layer 145 in order to fine-tune and optimize its chemical properties, such as its electrochemical potential, its energy, its power performance, and its reversible lattice parameters on electrochemical and thermal cycling. Examples of methods used to deposit LiCoO₂ are disclosed in U.S. patent application Ser. No. 11/557,383, filed on November 7, 2006.

The semiconducting surface or the conductive or insulating packaging surface of a semiconductor device in the above embodiments may be part of any integrated circuit and may include, memory devices, processors or other logic circuits.

Another embodiment of the present invention includes a battery deposited on a flexible printed circuit board including, for example, a first electrical contact; a bonding layer coupled with the first electrical contact and having an embedded conductor; at least one battery cell structure; and a flexible printed circuit board. A bonding layer and the at least one battery cell structure may be sandwiched between the first contact layer and the flexible printed circuit board. The bonding layer may be selectively conductive through the embedded conductor. The battery cell structure may further be in selective electrical contact with the first electrical contact via the embedded conductor.

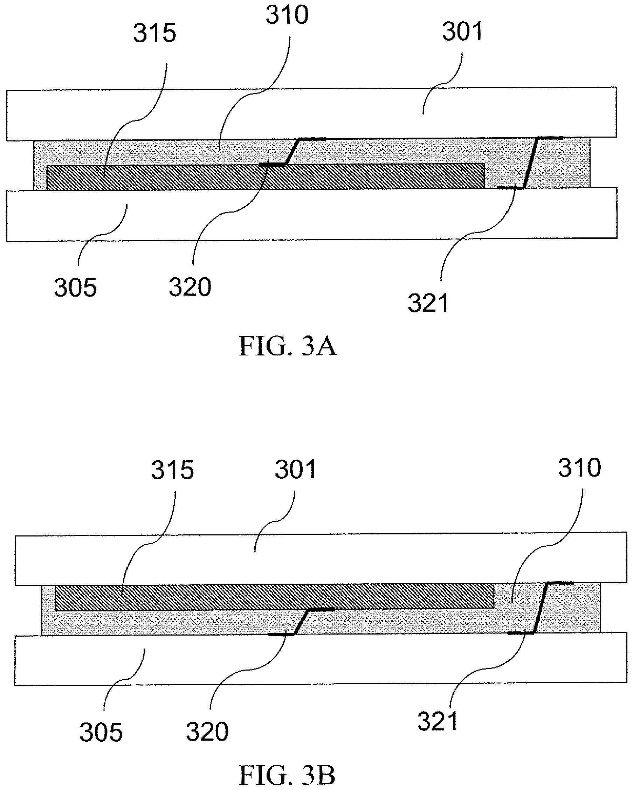

FIG. 3A shows a side view of an electrochemical device according to another embodiment of the present invention. In this embodiment, a first contact 301 is coupled with bonding layer 310 with a portion of the first contact 301 extending past the bonding layer 310. The bonding layer 310 may, for example, be bonded with the cell structure 315. A flexible printed circuit board 305 is placed under the battery cell structure 315. Shown embedded within the bonding layer 310 is a first embedded conductor 320. This first embedded conductor 320, for example, creates a selectively conductive bonding layer. A selectively conductive bonding layer 310 permits conduction from the cell structure 315 through the bonding layer 310 to the first contact 301 at specific points, and yet provides insulation between the first contact 301 and the flexible circuit board 305. Also shown embedded within the bonding layer 310 is the second embedded conductor 321. This second conductor, for example, further creates a selectively conductive bonding layer. The further selectively conductive boding layer 310 permits conduction from the flexible printed circuit board 305 through the bonding layer 310 to the first contact 301 at specific points, and yet provides insulation between the first contact 301 and the flexible printed circuit board 305. Other types of battery cell structures may be also be included.

FIG. 3B shows a side view of an electrochemical device according to one exemplary embodiment of the present invention. In this embodiment, a first contact 301 is coupled with the battery cell structure 315. A bonding layer 310 is coupled to the battery cell structure 315 and a portion of the first contact 301, which extends past the bonding layer 310. A flexible printed circuit board 305 is coupled with the bonding layer 310. Shown embedded within the bonding layer 310 is the first embedded conductor 320. This first embedded conductor 320, for example, creates a selectively conductive bonding layer. A selectively conductive bonding layer 310 permits conduction from the cell structure 315 through the bonding layer 310 to the flexible printed circuit board 305 at specific points, and yet provides insulation between the first contact 301 and the flexible printed circuit board 305. The electrochemical device may have a second embedded conductor 321 that selectively creates an electrical contact between the first contact 301 and the flexible printed circuit board 305. In this case, the flexible printed circuit board 305 must be selectively insulating between the contacts points at which the first embedded conductor 320 and the second embedded conductor 321 meet the flexible printed circuit board 305.

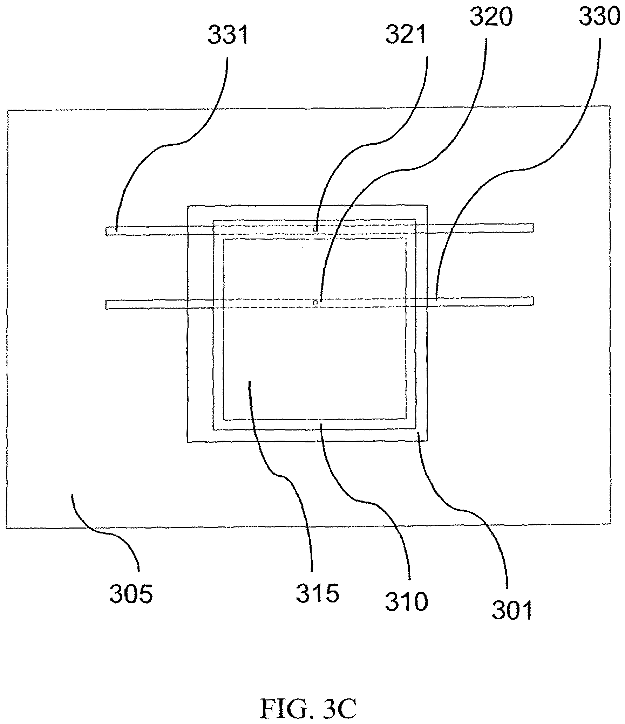

FIG. 3C is a top view of an exemplary electrochemical device integrated with a flexible circuit board 305, such as the exemplary devices described above with respect to FIGS. 3 A and 3B. As shown in FIG. 3C, conductive traces 330, 331 are formed on a surface of the circuit board 305. Other types of conductive surfaces, such as contact pads, wiring, exposed conductive vias etc., or combinations thereof may be provided on the circuit board surface to receive the electrochemical device. In the plan view, the first embedded conductor 320 is shown passing through bonding layer 310 to make electrical contact with conductive trace 330, and the second embedded conductor 321 is shown passing through bonding layer 310 to make electrical contact with conductive trace 331. It should be appreciated that an analogous arrangement can be achieved with respect to the examples including a semiconducting surface or the conductive or insulating packaging surface of a semiconductor device, as described above with respect to FIGS. IA and IB.

The flexible circuit board 305 may comprise, for example, multiple circuit board layers with and without traces, single or double sided, semi-rigid, a film, and/or a polyimide film.

The embedded conductors 320 and 321 may be placed within the bonding layer 310 in many different ways. For example, a metal tab, a metal wire, a metal strip, a metal ribbon, multiple metal wires, multiple metal strips, multiple metal ribbons, a metal wire mesh, perforated metal foil, perforated metal, a metal coating applied to the adhesive layer, a metallic disk, a metallically coated fiberglass or combinations thereof may be used. In each of these examples, the first embedded conductor 320 can provide selective electrical conduction between the cell structure 315 and the first contact 301 or the flexible printed circuit board 305, and yet provide insulation between the battery cell structure 315 and the first contact 301 or the flexible printed circuit board 305. Also in each of these examples, the second embedded conductor 321 can provide selective electrical conduction between the first contact 301 and the flexible printed circuit board 305 and yet provide insulation between the first contact 301 and the flexible printed circuit board 305. In some embodiments the first embedded conductor 320 may be woven within the bonding layer 310. The first embedded conductor 320 may be, for example, disks embedded within the bonding layer 310. In some embodiments slits within the bonding layer 310 may be made in order to weave or place the first embedded conductor 320 through the bonding layer 310. Also, for example, holes or other means may be used to place the first embedded conductor 320 through the bonding layer 310. In some embodiments the second embedded conductor 321 may be woven within the bonding layer 310. The second embedded conductor 321 may be, for example, disks embedded within the bonding layer 310. In some embodiments slits within the bonding layer 310 may be made in order to weave or place the second embedded conductor 321 through the bonding layer 310. Also, for example, holes or other means may be used to place the second embedded conductor 321 through the bonding layer 310.

The electrochemical device 315 may include a cathode, anode and electrolyte. For example, the cathode may comprise LiCoO₂, the anode may comprise Lithium and the electrolyte may comprise LIPON. Other electrochemical devices may be used as needed.

The electrochemical device 315 may be coupled with the flexible printed circuit board 305 in a number of ways. In one embodiment, the electrochemical device 315, for example, may be coupled with the flexible printed circuit board 305 using glue. Glue, as used in this application, extends to any material that may adhere the electrochemical device 315 to the flexible printed circuit board 305. The glue may create either a mechanical or chemical bond between the two layers. Glue may also include chemically bonding the two layers without introducing another material or layer. Glue, for example, may include but is not limited to cement glue and resin glue. The glue may be electrically conducting, semi-conducting, or insulating.

The electrochemical device 315 may be coupled with the first electrical contact 301 in a number of ways. In one embodiment, the electrochemical device 315, for example, may be coupled with the first electrical contact 301 using glue. Glue, as used in this application, extends to any material that may adhere the electrochemical device 315 to the first electrical contact 301. The glue may create either a mechanical or chemical bond between the two layers. Glue may also include chemically bonding the two layers without introducing another material or layer. Glue, for example, may include but is not limited to cement glue and resin glue. The glue may be electrically conducting, semi-conducting, or insulating.

In another embodiment the flexible printed circuit board 305 acts as a substrate for the battery, which may be deposited thereon.

In another embodiment the first electrical contact 301 acts as a substrate for the battery, which may be deposited thereon.

In another embodiment the flexible printed circuit board 305 acts as an encapsulate for the battery.

In another embodiment the first electrical contact 301 acts as an encapsulate for the battery.

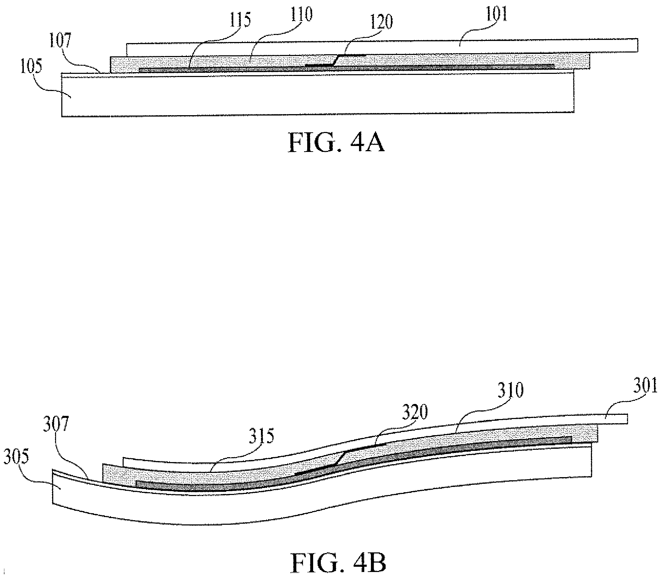

In another exemplary embodiment shown in FIG. 4A, a thin film battery is provided on a semiconducting surface or the conductive or insulating surface of a semiconductor device with a barrier layer therebetween. Elements depicted in Figure 4A like those above in FIG. IA are shown having the same reference numbers. In this embodiment, a first contact 101 is coupled with bonding layer 110 with a portion of the first contact 101 extending past the bonding layer 110. The bonding layer 110 may, for example, be bonded with the cell structure 115. A semiconducting surface or the conductive or insulating (e.g., packaging) surface of a semiconductor device 105 with a barrier layer 107 is placed under the battery cell structure 115.

In this embodiment, barrier layer 107 may include, for example, titanium nitride. The barrier layer 107 may also comprise a semiconducting surface or the conductive or insulating packaging surface of a semiconductor device 105. A conductive surface may include, for example, a conductive contact pad, a conductive line, conductive via or other conductive layer formed on or at the device surface. A conductive surface also may be formed together with an insulating surface, such as a conductive surface formed on a packaging surface of a semiconductor device. An insulating surface of the semiconductor device 105 may be, for example, an insulating packaging surface of a semiconductor device or an upper insulating surface the semiconductor device. Shown embedded within the bonding layer 110 is conductor 120. This conductor 120, for example, creates a selectively conductive bonding layer. A selectively conductive bonding layer 110 permits conduction from the cell structure 115 through the bonding layer 110 to the first contact 101 at specific points, and yet provides insulation between the first contact 101 and the barrier layer 107. Other types of battery cell structures may be also be included.

The electrochemical device 115 may be coupled with the semiconducting surface or the conductive or insulating (e.g., packaging) surface of a semiconductor device 105 and barrier layer 107 in a number of ways. In one embodiment, the electrochemical device, for example, may be coupled with the barrier layer using glue. Glue, as used in this application, extends to any material that may adhere the electrochemical device 115 to the barrier layer 107. The glue may create either a mechanical or chemical bond between the two layers. Glue may also include chemically bonding the two layers without introducing another material or layer. Glue, for example, may include but is not limited to cement glue and resin glue. The glue may be electrically conducting, semi-conducting, or insulating.

In another exemplary embodiment the semiconducting surface or the conductive or insulating packaging surface of a semiconductor device 105 acts as a substrate for the battery. The semiconducting surface or the conductive or insulating packaging surface of a semiconductor device 105 is provided and the barrier layer 107 may be deposited thereon. The barrier layer 107 may also be glued to the semiconducting surface or the conductive or insulating packaging surface of a semiconductor device 105. Once the barrier layer 107 and the substrate 105 have been prepared, the electrochemical device 115 may be deposited directly on the barrier layer 107.

In an exemplary embodiment, a LiCoO₂ cathode layer is deposited on the barrier layer 107 by way of methods described above.

In yet another exemplary embodiment shown in FIG. 4B, a thin film battery is provided on a flexible circuit board. Elements depicted in Figure 4B like those above in FIG. 3A are shown having the same reference numbers. In this embodiment, a first contact 301 is coupled with bonding layer 310 with a portion of the first contact 301 extending past the bonding layer 310. The bonding layer 310 may, for example, be bonded with the cell structure 315. A flexible printed circuit board 305, such as described above, and a barrier layer 307 is placed under the battery cell structure 315. In this embodiment, the barrier layer 307 may, for example, include titanium nitride. Shown embedded within the bonding layer 310 is conductor 320. This conductor 320, for example, creates a selectively conductive bonding layer. A selectively conductive bonding layer 310 permits conduction from the cell structure 315 through the bonding layer 310 to the first contact 301 at specific points, and yet provides insulation between the first contact 301 and the barrier layer 307. The conductor 320 may be provided within the bonding layer 310 as described above. In each of these examples, the conductor 320 can provide electrical conduction between the cell structure 315 and the first contact 301 and yet provide insulation between the first contact 301 and the barrier layer 307.

The electrochemical device 315 may be coupled with the semiconducting surface or the conductive or insulating packaging surface of a semiconductor device 305 and barrier layer 307 in a number of ways. In one embodiment, the electrochemical device, for example, may be coupled with the barrier layer using glue. Glue, as used in this application, extends to any material that may adhere the electrochemical device 315 to the barrier layer 307. The glue may create either a mechanical or chemical bond between the two layers. Glue may also include chemically bonding the two layers without introducing another material or layer. Glue, for example, may include but is not limited to cement glue and resin glue. The glue may be electrically conducting, semi-conducting, or insulating.

In another embodiment the flexible printed circuit board 305 acts as a substrate for the battery and the barrier layer 307 may be deposited thereon. The barrier layer 307 may also be glued to the flexible printed circuit board 305. Once the barrier layer 307 and the printed circuit board 305 have been prepared, the electrochemical device 315 may be deposited directly on the barrier layer 307.

While FIGS. 4A and 4B show only one conductor 120, 320, respectively, it is to be understood that exemplary embodiments also may include at least one second conductor, such as conductors 121, 321, respectively described above in connection with FIGS. IA and 3A. Further, electrical connection between the first contact 101, 301 and the underlying semiconducting surface, conductive or insulating surface of a semiconductor device, or a flexible circuit board can be made by conductors 121, 321 through the bonding and/or barrier layers.

The above-discussed exemplary embodiments may also include multiple electrochemical devices stacked upon a semiconducting surface or the conductive or insulating (e.g., packaging) surface of a semiconductor device.

The above-discussed exemplary embodiments may also include multiple electrochemical devices stacked upon the first electrical contact 301.

The present exemplary embodiments provide alternative schemes to encapsulate the chemically and mechanically sensitive layers of electrochemical devices, which are less expensive than prior encapsulation schemes using gold foil. The above exemplary embodiments also avoid problems of other prior schemes relating to blow out of the seals of a metal and plastic pouch encapsulating an electrochemical device resulting from temperature changes, which cause the gas within the metal and plastic pouch to expand and/or contract.

The exemplary embodiments described herein also provide a rechargeable secondary battery directly fabricated on a semiconductor device such as an integrated circuit. Such batteries provide power during times when the circuit is powered off and are quickly and easily recharged when power resumes. Critical circuitry may benefit from localized power provided by such batteries. The exemplary embodiments also provide for less expensive and more reliable encapsulating approaches, and better approaches to providing electrically conductive contacts, including encapsulation that is substantially thinner than known encapsulation methods. The exemplary embodiments also provide flexible integrated circuits and/or flexible printed circuit boards with thin film flexible batteries coupled thereon.

Although the above examples describe a conductive material provided in an opening in the bonding layer, such as the slit, it should be appreciated that electrical contact between the battery cell structure 115, 315 and first electrical contact 101, 301 may be provided by a number of other ways. For example, embedding a conductive powder within an adhesive forming the bonding layer 110, 310 may provide electrical conduction between the cell structure 115, 315 and the first contact 101, 301. For example, a conductive powder such as a metallic powder (e.g., nickel powder) can be embedded in an adhesive bonding layer 110, 310 at one or more selected areas within an adhesive bonding layer 110, 310 and between the contact 101, 301 and the battery cell structure 115, 315. Those skilled in the art will appreciate other conductive materials that may be provided for the selective conduction, such as conductive balls, slugs, wiring mesh etc. selectively provided within an adhesive. The ways to achieve electrical conduction between the battery cell structure 115, 315 and the first contact 101, 301 and yet provide insulation between the contacts and battery cell structure, should not be considered as limited to the examples explained herein.

The same holds true for the electrical contact between the battery cell structure 115, 315 and the semiconducting surface or the conductive or insulating packaging surface of a semiconductor device 105 or the flexible printed circuit board 305. The same also holds true for the electrical contact between the first contact 101, 301 and the semiconducting surface or the conductive or insulating packaging surface of a semiconductor device 105 or the flexible printed circuit board 305.

Additionally, it should be appreciated that the electrochemical device may comprise a discrete device (e.g., fully packaged with its own substrate and own encapsulation) on a semiconductor surface, a conducting or insulating surface of a semiconductor device or a flexible printed circuit board. For example, prior to its integration onto the semiconducting surface or a conductive or insulating surface of a semiconductor device or into or onto a flexible printed circuit board, the electrochemical device may be fabricated as a discrete device, and then integrated as a whole together with its substrate and its encapsulation.

The embodiments described above are exemplary only. One skilled in the art may recognize variations from the embodiments specifically described here, which are intended to be within the scope of this disclosure. As such, the invention is limited only by the following claims. Thus, it is intended that the present invention cover the modifications of this invention provided they come within the scope of the appended claims.

## Claims

1. An integrated circuit including a battery, comprising:
a semiconductor device (105) or a flexible printed circuit board (305) having a surface;
a bonding layer (110; 310) coupled with the surface of the semiconductor device or the flexible printed circuit board, the bonding layer comprising a first embedded conductor (120; 320);
a battery cell structure (115; 315) in selective electrical contact with the surface of the semiconductor device or the flexible printed circuit board via the first embedded conductor (120; 320); and
a first electrical contact (101; 301) coupled with the battery cell structure, wherein the bonding layer (110) and the battery cell structure (115) are sandwiched between the surface of the semiconductor device or the flexible printed circuit board and the first electrical contact (101); and
a second embedded conductor (121; 321) embedded in the bonding layer (110), the surface of the semiconductor device or the flexible printed circuit board in selective electrical contact with the first electrical contact (101) via the second embedded conductor (121; 321).

2. The integrated circuit of claim 1, wherein the surface of the semiconductor device is selected from a group consisting of a semiconducting surface, a conductive surface, and an insulating packaging surface, and preferably
wherein the surface of the semiconductor device or the flexible printed circuit board acts as an encapsulate of the battery cell structure.

3. The integrated circuit of claim 1, further comprising a barrier layer between the battery cell structure and the first electrical contact, and/or
further comprising a substrate sandwiched between the battery cell structure and the first electrical contact.

4. The integrated circuit of claim 1, further comprising an encapsulate sandwiched between the bonding layer and the surface.

5. The integrated circuit of claim 1, wherein the first electrical contact comprises an encapsulate metal.

6. The integrated circuit of claim 1, wherein the bonding layer comprises a material selected from a group consisting of an adhesive material, an insulating material, plastic, glass, reinforcement materials, and fiberglass.

7. The integrated circuit of claim 1, wherein the semiconductor device or the flexible printed circuit board is in selective electrical contact with a bottom surface of the battery cell structure via the first embedded conductor.

8. The integrated circuit of claim 1, wherein the embedded conductor is woven within the bonding layer, and preferably
wherein the bonding layer comprises a slit within which the embedded conductor is woven.

9. A method of manufacturing a battery on a first electrical contact comprising:
creating a selectively conductive bonding layer (110; 310) comprising a first embedded conductor;
coupling the bonding layer with a surface of a semiconductor device (105) or a flexible printed circuit board (305);
coupling a first side of a battery cell structure (115; 315) with a first electrical contact (101; 301); and
coupling a second side of the battery cell structure with the bonding layer;
electrically contacting said second side of said battery cell structure with said surface of a semiconductor device (105) or a flexible printed circuit board (305) via said first embedded conductor; and
coupling said first electrical contact with said surface of a semiconductor device (105) or a flexible printed circuit board (305) via a second embedded conductor embedded in the bonding layer.

10. The method of claim 9, wherein the surface of the semiconductor device, with which the bonding layer is coupled, is one of a semiconducting surface, a conductive surface or an insulating surface.

11. The method of claim 9, wherein the coupling of the first side of the battery cell structure with the first electrical contact comprises gluing the first side of the battery cell structure to the first electrical contact.

12. The method of claim 9 further comprising providing a substrate that is sandwiched between the first side of the battery cell structure and first electrical contact, and preferably
further comprising providing an encapsulate that is sandwiched between the bonding layer and the surface.

## Patentansprüche

1. Integrierte Schaltung, die eine Batterie beinhaltet, umfassend:
eine Halbleitervorrichtung (105) oder eine flexible gedruckte Leiterplatte (305), die eine Oberfläche aufweist;
eine Bindeschicht (110; 310), die mit der Oberfläche der Halbleitervorrichtung oder der flexiblen gedruckten Leiterplatte gekoppelt ist, wobei die Bindeschicht einen ersten eingebetteten Leiter (120; 320) umfasst;
eine Batteriezellenstruktur (115; 315), die in einem wahlweisen elektrischen Kontakt mit der Oberfläche der Halbleitervorrichtung oder der flexiblen gedruckten Leiterplatte über den ersten eingebetteten Leiter (120; 320) steht; und
einen ersten elektrischen Kontakt (101; 301), der mit der Batteriezellenstruktur gekoppelt ist, wobei die Bindeschicht (110) und die Batteriezellenstruktur (115) zwischen der Oberfläche der Halbleitervorrichtung oder der flexiblen gedruckten Leiterplatte und dem ersten elektrischen Kontakt (101) eingeschlossen ist; und
einen zweiten eingebetteten Leiter (121; 321), der in der Bindeschicht (110) eingebettet ist, wobei die Oberfläche der Halbleitervorrichtung oder der flexiblen gedruckten Leiterplatte in wahlweisem elektrischen Kontakt mit dem ersten elektrischen Kontakt (101) über den zweiten eingebetteten Leiter (121; 321) steht.

2. Integrierte Schaltung nach Anspruch 1, wobei die Oberfläche der Halbleitervorrichtung ausgewählt ist aus der Gruppe bestehend aus einer Halbleiteroberfläche, einer leitenden Oberfläche und einer isolierenden Packungsoberfläche, und vorzugsweise
wobei die Oberfläche der Halbleitervorrichtung oder der flexiblen gedruckten Leiterplatte als eine Einkapselung der Batteriezellenstruktur wirken.

3. Integrierte Schaltung nach Anspruch 1, ferner eine Barriereschicht zwischen der Batteriezellenstruktur und dem ersten elektrischen Kontakt umfassend, und/oder
ferner ein Substrat umfassend, welches zwischen der Batteriezellenstruktur und dem ersten elektrischen Kontakt eingeschlossen ist.

4. Integrierte Schaltung nach Anspruch 1, ferner eine Einkapselung umfassend, die zwischen der Bindeschicht und der Oberfläche eingeschlossen ist.

5. Integrierte Schaltung nach Anspruch 1, wobei der erste elektrische Kontakt eine Metalleinkapselung umfasst.

6. Integrierte Schaltung nach Anspruch 1, wobei die Bindeschicht ein Material ausgewählt aus der Gruppe bestehend aus einem klebenden Material, einem isolierenden Material, einem Kunststoff, einem Glas, Verstärkungsmaterialien und Fiberglas umfasst.

7. Integrierte Schaltung nach Anspruch 1, wobei die Halbleitervorrichtung oder die flexible gedruckte Leiterplatte in wahlweisem elektrischem Kontakt mit einer unteren Oberfläche der Batteriezellenstruktur über den ersten eingebetteten Leiter steht.

8. Integrierte Schaltung nach Anspruch 1, wobei der eingebettete Leiter in die Bindeschicht gewebt ist, und vorzugsweise
wobei die Bindeschicht einen Schlitz umfasst, in welchen der eingebettete Leiter gewebt ist.

9. Verfahren zum Herstellen einer Batterie auf einem ersten elektrischen Kontakt, wobei das Verfahren umfasst:
Erzeugen einer wahlweisen leitenden Bindeschicht (110; 310), die einen ersten eingebetteten Leiter umfasst;
Koppeln der Bindeschicht mit einer Oberfläche einer Halbleitervorrichtung (105) oder einer flexiblen gedruckten Leiterplatte (305);
Koppeln einer ersten Seite einer Batteriezellenstruktur (115; 315) mit einem ersten elektrischen Kontakt (101; 301); und
Koppeln einer zweiten Seite der Batteriezellenstruktur mit der Bindeschicht;
elektrisch in Kontakt bringen der zweiten Seite der Batteriezellenstruktur mit der Oberfläche einer Halbleitervorrichtung (105) oder einer flexiblen gedruckten Leiterplatte (305) über den ersten eingebetteten Leiter; und Koppeln des ersten elektrischen Kontakts mit der Oberfläche einer Halbleitervorrichtung (105) oder einer flexiblen gedruckten Leiterplatte (305) über einen zweiten eingebetteten Leiter, der in der Bindeschicht eingebettet ist.

10. Verfahren nach Anspruch 9, wobei die Oberfläche der Halbleitervorrichtung, mit welcher die Bindeschicht gekoppelt ist, eine Halbleiteroberfläche oder eine leitende Oberfläche oder eine isolierende Oberfläche ist.

11. Verfahren nach Anspruch 9, wobei das Koppeln der ersten Seite der Batteriezellenstruktur mit dem ersten elektrischen Kontakt ein Kleben der ersten Seite der Batteriezellenstruktur an den ersten elektrischen Kontakt umfasst.

12. Verfahren nach Anspruch 9, ferner ein Bereitstellen eines Substrats umfassend, welches zwischen der ersten Seite der Batteriezellenstruktur und dem ersten elektrischen Kontakt eingeschlossen ist, und vorzugsweise ferner ein Bereitstellen einer Einkapselung umfassend, die zwischen der Bindeschicht und der Oberfläche eingeschlossen ist.

## Revendications

1. Un circuit intégré comprenant une batterie, comprenant :
un composant semi-conducteur (105) ou une carte de circuit imprimé flexible (305) présentant une surface ;
une couche de liaison (110 ; 310) couplée à la surface du composant semi-conducteur ou de la carte de circuit imprimé flexible, la couche de liaison comprenant un premier conducteur incorporé (120 ; 320) ;
une structure de cellule de batterie (115 ; 315) en contact électrique sélectif avec la surface du composant semi-conducteur ou de la carte de circuit imprimé flexible via le premier conducteur incorporé (120 ; 320) ; et
un premier contact électrique (101 ; 301) couplé à la structure de cellule de batterie, la couche de liaison (110) et la structure de cellule de batterie (115) étant prises en sandwich entre la surface du composant semi-conducteur ou de la carte de circuit imprimé flexible et le premier contact électrique (101) ; et
un second conducteur incorporé (121 ; 321) incorporé dans la couche de liaison (110), la surface du composant semi-conducteur ou de la carte de circuit imprimé flexible étant en contact électrique sélectif avec le premier contact électrique (101) via le second conducteur incorporé (121 ; 321).

2. Le circuit intégré de la revendication 1, dans lequel la surface du composant semi-conducteur est choisie dans un groupe constitué d'une surface semi-conductrice, une surface conductrice et une surface de conditionnement isolant, et de préférence
dans lequel la surface du composant semi-conducteur ou de la carte de circuit imprimé flexible joue le rôle d'une encapsulation de la structure de cellule de batterie.

3. Le circuit intégré de la revendication 1, comprenant en outre une couche de barrière entre la structure de cellule de batterie et le premier contact électrique, et/ou
comprenant en outre un substrat pris en sandwich entre la structure de cellule de batterie et le premier contact électrique.

4. Le circuit intégré de la revendication 1, comprenant en outre une encapsulation prise en sandwich entre la couche de liaison et la surface.

5. Le circuit intégré de la revendication 1, dans lequel le premier contact électrique comprend un métal d'encapsulation.

6. Le circuit intégré de la revendication 1, dans lequel la couche de liaison comprend un matériau choisi dans un groupe constitué par un matériau adhésif, un matériau isolant, du plastique, du verre, des matériaux de renfort et de la fibre de verre.

7. Le circuit intégré de la revendication 1, dans lequel le composant semi-conducteur ou la carte de circuit imprimé flexible est en contact électrique sélectif avec une surface de dessous de la structure de cellule de batterie via le premier conducteur incorporé.

8. Le circuit intégré de la revendication 1, dans lequel le conducteur incorporé est tissé à l'intérieur de la couche de liaison, et de préférence
dans lequel la couche de liaison comprend une fente à l'intérieur de laquelle est tissé le conducteur incorporé.

9. Un procédé de fabrication d'une batterie sur un premier contact électrique, comprenant :
la création d'une couche de liaison sélectivement conductrice (110 ; 310) comprenant un premier conducteur incorporé ;
le couplage de la couche de liaison à une surface d'un composant semi-conducteur (105) ou d'une carte de circuit imprimé flexible (305) ;
le couplage d'un premier côté d'une structure de cellule de batterie (115 ; 315) à un premier contact électrique (101 ; 301) ; et
le couplage d'un second côté de la structure de cellule de batterie à la couche de liaison ;
la mise en contact électrique dudit second côté de ladite structure de cellule de batterie avec ladite surface du composant semi-conducteur (105) ou de la carte de circuit imprimé flexible (305) via ledit premier conducteur incorporé ; et
le couplage dudit premier contact électrique à ladite surface du composant semi-conducteur (105) ou de la carte de circuit imprimé flexible (305) via un second conducteur incorporé, incorporé dans la couche de liaison.

10. Le procédé de la revendication 9, dans lequel la surface du composant semi-conducteur, à laquelle est couplée la couche de liaison, est l'une d'entre une surface semi-conductrice, une surface conductrice ou une surface isolante.

11. Le procédé de la revendication 9, dans lequel le couplage du premier côté de la structure de cellule de batterie au premier contact électrique comprend le collage du premier côté de la structure de cellule de batterie au premier contact électrique.

12. Le procédé de la revendication 9, comprenant en outre la mise en place d'un substrat qui est pris en sandwich entre le premier côté de la structure de cellule de batterie et le premier contact électrique, et de préférence
comprenant en outre la mise en place d'une encapsulation qui est prise en sandwich entre la couche de liaison et la surface.
